(19) Europäisches Patentamt / European Patent Office / Office européen des brevets

(11) EP 4 089 141 A1

(12) EUROPEAN PATENT APPLICATION

(43) Date of publication: **16.11.2022 Bulletin 2022/46**

(21) Application number: **22169009.2**

(22) Date of filing: **20.04.2022**

(51) International Patent Classification (IPC): ***C08K 3/36*** *(2006.01)* ***C08L 63/00*** *(2006.01)*

(52) Cooperative Patent Classification (CPC): (C-Sets available) **C08K 3/36;** C08K 5/0025; C08K 2003/2227 (Cont.)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.05.2021 JP 2021080711**

(71) Applicant: **Shin-Etsu Chemical Co., Ltd. Tokyo 100-0005 (JP)**

(72) Inventors:
- **Osada, Shoichi Gunma, 379-0224 (JP)**
- **Kawamura, Norifumi Gunma, 379-0224 (JP)**
- **Horigome, Hiroki Gunma, 379-0224 (JP)**
- **Hagiwara, Kenji Gunma, 379-0224 (JP)**
- **Yokota, Ryuhei Gunma, 379-0224 (JP)**

(74) Representative: **Angerhausen, Christoph Boehmert & Boehmert Anwaltspartnerschaft mbB Pettenkoferstrasse 22 80336 München (DE)**

# (54) RESIN COMPOSITION FOR ENCAPSULATION AND SEMICONDUCTOR DEVICE

(57) Provided are a resin composition for encapsulation that is superior in high-temperature reverse bias test (HTRB test) reliability; and a semiconductor device. The resin composition for encapsulation is used to encapsulate a power semiconductor element made of Si, SiC, GaN, $Ga_2O_3$ or diamond, and a cured product of the resin composition for encapsulation has a dielectric tangent of not larger than 0.50 when measured at 150°C and 0.1 Hz. The semiconductor device is such that a power semiconductor element made of Si, SiC, GaN, $Ga_2O_3$ or diamond is encapsulated by the cured product of the resin composition for encapsulation.

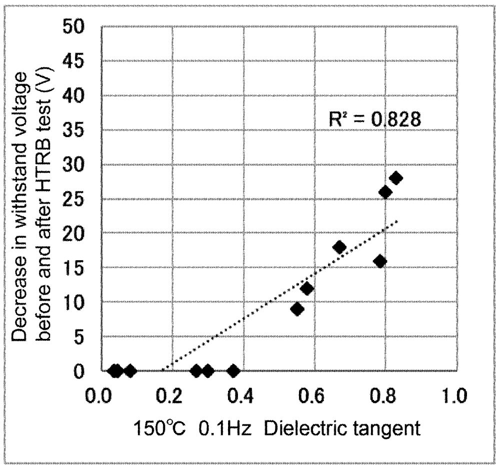






(Cont. next page)

(52) Cooperative Patent Classification (CPC): (Cont.)

C-Sets
**C08K 3/36, C08L 63/00**

## Description

Field of the invention

The present invention relates to a resin composition for encapsulation and a semiconductor device.

Background art

In recent years, due to progress made in energy saving for household electrical appliances and in hybridization and electrical automation of vehicles, there are now used more semiconductor devices (power semiconductor devices) equipped with a power semiconductor element(s) as typified by an insulated gate bipolar transistor (IGBT) and a metal-oxide-semiconductor field-effect transistor (MOS-FET). A power semiconductor is one type of a semiconductor element mainly used to, for example, control the voltage or frequency of an electric power, and convert a direct current into an alternate current or an alternate current into a direct current; a power semiconductor device is required to possess an electric reliability capable of withstanding even a usage under a high-voltage and high-current condition. As for a power semiconductor device, for example, it is required that a leakage current generated in a high-temperature reverse bias test (HTRB test) be sufficiently small. HTRB test is a testing method for checking an electric reliability as specified in MIL-STD-750-1 or the like, where a power semiconductor device is to be stored under a high temperature with a reverse bias of a DC high voltage being applied thereto, the device is then cooled to room temperature after a given period of time has elapsed, and the bias is finally turned off to verify whether there has been an increase in leakage current. Here, the given period of time may for example be about 1 to 1,000 hours; the high temperature may for example be about 150 to 175°C; and the high voltage may for example be several hundred to several thousand volts. An increase in leakage current may occur as an electric field occurs in an encapsulation resin that is in contact with an element surface to which the reverse bias is applied (JP-A-Sho 61-81426).

As a method for evaluating the electric field occurring in the encapsulation resin that is in contact with the element surface to which the reverse bias is applied, there has been reported examples for measuring the dielectric properties of the encapsulation resin (JP-A-2020-158684 and WO2019/035430). This is because it is assumed that during a reverse bias application, leakage currents increase if an encapsulation resin is easily polarizable.

In JP-A-2020-158684, there is a description that the permittivity of a cured product of an encapsulation resin is 2.80 to 4.40 when measured at 25°C and 20 Hz, and 2.80 to 4.40 when measured at 25°C and 100 Hz; since a high-temperature reverse bias test is performed at a temperature of 150 to 175°C with a DC high voltage being applied, cases where no increase in leakage current has occurred may be observed even when the permittivity is not lower than 4.40 at 20 Hz.

In WO2019/035430, there is a description that a dielectric relaxation value of a cured product of an encapsulation resin is not higher than 20 when measured at a frequency of 0.001 Hz. Here, a measurement temperature is not specified; the definition of the measurement item "dielectric relaxation" is unclear, and the measurement item itself is not common; a long measurement time is required due to the ultralow frequency of 0.001 Hz; and there is a huge impact caused by the moisture absorption of a sample. For these reasons, it is difficult for those skilled in the art to check the electric reliability of an encapsulation resin based on the dielectric relaxation value by the method described in WO2019/035430.

SUMMARY OF THE INVENTION

Thus, it is an object of the present invention to provide a resin composition for encapsulation that is superior in HTRB test reliability; and a semiconductor device.

The inventors of the present invention diligently conducted a series of studies, and completed the invention as follows. Specifically, the inventors found that by appropriately controlling a dielectric tangent of a cured product of a resin composition for encapsulation that is measured at a high temperature of 150°C and a low frequency of 0.1 Hz, in a semiconductor device produced using such resin composition for encapsulation, leakage currents in a HTRB test can be reduced, and a HTRB test reliability of the semiconductor device can thus be improved.

That is, the present invention is to provide the following resin composition for encapsulation; and the following semiconductor device.

[1] A resin composition for encapsulation used to encapsulate a power semiconductor element made of Si, SiC, GaN, $Ga_2O_3$ or diamond, wherein a cured product of the resin composition for encapsulation has a dielectric tangent of not larger than 0.50 when measured at 150°C and 0.1 Hz.
[2] The resin composition for encapsulation according to [1], comprising a heat-curable resin.
[3] The resin composition for encapsulation according to [2], wherein the heat-curable resin is an epoxy resin.
[4] The resin composition for encapsulation according to [3], wherein the epoxy resin contains at least one selected

from the group consisting of a trisphenolmethane-type epoxy resin, an alkyl-modified trisphenolmethane-type epoxy resin, a phenol aralkyl-type epoxy resin having a biphenylene skeleton and a dicyclopentadiene-modified phenol-type epoxy resin.

[5] The resin composition for encapsulation according to [3], wherein the epoxy resin has an epoxy equivalent of 220 to 300 g/eq.

[6] The resin composition for encapsulation according to any one of [1] to [5], further comprising an inorganic filler.

[7] The resin composition for encapsulation according to [6], wherein the inorganic filler contains silicas.

[8] A semiconductor device wherein a power semiconductor element made of Si, SiC, GaN, $Ga_2O_3$ or diamond is encapsulated by a cured product of the resin composition for encapsulation according to any one of [1] to [7].

According to the present invention, provided are a resin composition for encapsulation that is superior in HTRB test reliability; and a semiconductor device.

BRIEF DESCRIPTION OF THE DRAWINGS

FIG.1 is a graph plotting decreases in withstand voltage (V) before and after HTRB test with respect to values of dielectric tangent measured at 150°C and 0.1 Hz, in the case of a cured product of a composition prepared in each of working and comparative examples.

DETAILED DESCRIPTION OF THE INVENTION

The present invention is described in greater detail hereunder.

A cured product of the resin composition for encapsulation of the present invention has a dielectric tangent of not larger than 0.50 when measured at a temperature of 150°C and a frequency of 0.1 Hz.

While the resin composition for encapsulation is an insulating material, the lower the permittivity thereof , the more preferable it is in terms of preventing electric charges from accumulating; and the lower the dielectric loss and dielectric tangent thereof, the more preferable it is in terms of preventing a leakage current. In general, since permittivity, dielectric loss and dielectric tangent depend on temperature and frequency, they are measured at various temperatures and frequencies in accordance with intended uses and purposes. As described in detail hereunder, in the present invention, it was found that a dielectric tangent of the cured product of the resin composition for encapsulation that is measured at 150°C and 0.1 Hz serves as an index for electric reliability after a HTRB test; based on such index, the present invention is to provide a resin composition for encapsulation of power semiconductor elements that is superior in electric reliability.

Components composing a resin composition for encapsulation are, for example, a heat-curable resin as typified by an epoxy resin, an inorganic filler, a curing agent, a curing accelerator, a mold release agent and a flame retardant; the polar groups in these components heavily impact on the dielectric properties of the cured product of the resin composition for encapsulation.

Particularly, in a low-frequency region, there is observed a behavior where the dipoles derived from the polar groups move according to changes in the electric field. That is, the permittivity, dielectric loss and dielectric tangent of the cured product of the resin composition for encapsulation will increase such that the dielectric loss and dielectric tangent may exhibit a maximum value(s). Here, the low-frequency region refers to a region where the frequency is not higher than 1 Hz, particularly not higher than 0.1 Hz. However, in a region of not higher than 0.001 Hz, the measured values do not stabilize, and a longer period of time will be required for measurement, due to the large impact of a water content contained in the resin composition for encapsulation; 0.1 Hz is preferable as a frequency for measuring dielectric properties.

Further, in the low-frequency region, the higher the temperature, the more active the behavior of the polar group-derived dipoles moving in accordance with the changes in the electric field will become, such that the permittivity, dielectric loss and dielectric tangent will increase. Particularly, since the HTRB test is performed at 150 to 200°C, dielectric properties measured at 150 to 175°C are critical. That is, it is preferred that the cured product of the resin composition for encapsulation have a low permittivity, dielectric loss and dielectric tangent when measured at the temperature of 150°C and the frequency of 0.1 Hz.

After studying dielectric properties and a leakage current after the HTRB test, the inventors of the present invention found that the value of dielectric tangent has the highest correlation with the leakage current after the HTRB test. When the dielectric tangent was not higher than 0.50, the HTRB test reliability was favorable as no leakage current had occurred. Even in the case of dielectric loss, lower values thereof resulted in fewer leakage currents; it was favorable when the value of dielectric loss was not higher than 3.0. As for permittivity, while there were exhibited values of 3.0 to 8.0, no clear correlation was able to be confirmed.

Described below are components that are or may be contained in the resin composition for encapsulation of

the present invention.

Heat-curable resin

It is preferred that the resin composition for encapsulation of the present invention contain a heat-curable resin. Examples of such heat-curable resin include an epoxy resin; a phenolic resin; a cyclic imide compound having per each molecule at least one dimer acid skeleton, at least one linear alkylene group having six or more carbon atoms and at least two cyclic imide groups, a cyanate ester compound having per each molecule at least two cyanato groups, a cyclopentadiene compound and/or oligomers of these compounds; an oxetane resin; a (meth)acrylate resin; a terminal (meth)acrylic group-modified polyphenylene ether resin; an unsaturated polyester resin; a diallyl phthalate resin; and a maleimide resin. As for heat-curable resin, one kind thereof may be used alone, or two or more kinds thereof may be used in combination.

Among these heat-curable resins, preferred are an epoxy resin; a cyclic imide compound having per each molecule at least one dimer acid skeleton, at least one linear alkylene group having six or more carbon atoms and at least two cyclic imide groups, a cyanate ester compound having per each molecule at least two cyanato groups, a cyclopentadiene compound and/or oligomers of these compounds; an oxetane resin; a (meth)acrylate resin; a terminal (meth)acrylic group-modified polyphenylene ether resin; and an unsaturated polyester resin. An epoxy resin is particularly preferred in terms of a balance between dielectric property, curability, mechanical strength, adhesiveness to a base material, insulation property and cost.

As an epoxy resin, there may be used any monomers, oligomers or polymers having at least two epoxy groups per each molecule (i.e. polyfunctional). For example, there may be listed a biphenyl-type epoxy resin; a bisphenol-type epoxy resin such as a bisphenol A-type epoxy resin, a bisphenol F-type epoxy resin and a tetramethyl bisphenol F-type epoxy resin; a stilbene-type epoxy resin; a novolac-type epoxy resin such as a phenol novolac-type epoxy resin and a cresol novolac-type epoxy resin; a polyfunctional epoxy resin such as a trisphenolmethane-type epoxy resin and an alkyl-modified trisphenolmethane-type epoxy resin; a phenol aralkyl-type epoxy resin such as a phenol aralkyl-type epoxy resin having a phenylene skeleton, and a phenol aralkyl-type epoxy resin having a biphenylene skeleton; a naphthol-type epoxy resin such as a dihydroxynaphthalene-type epoxy resin, and an epoxy resin obtained by glycidyl etherifying a dimer of dihydroxynaphthalene; a triazine nucleus-containing epoxy resin such as triglycidyl isocyanurate and monoallyl diglycidyl isocyanurate; and a bridged cyclic hydrocarbon compound-modified phenol-type epoxy resin such as a dicyclopentadiene-modified phenol-type epoxy resin.

Of these, preferred are a trisphenolmethane-type epoxy resin, an alkyl-modified trisphenolmethane-type epoxy resin, a phenol aralkyl-type epoxy resin having a biphenylene skeleton and a dicyclopentadiene-modified phenol-type epoxy resin.

Any one kind of these epoxy resins may be used alone, or two or more kinds thereof may be used in combination. Since the polar groups generated when epoxy groups undergo ring-opening polymerization impact on dielectric properties, it is preferred that a total number of the epoxy groups in the composition be small, or that the behavior of these polar groups be electrically or sterically controlled by the substituent groups in the epoxy resin.

An epoxy equivalent of the epoxy resin is preferably in a range of 200 to 400 g/eq, more preferably 210 to 400 g/eq, even more preferably 220 to 300 g/eq.

When the epoxy equivalent is smaller than 200 g/eq, a polar group concentration will increase such that the dielectric tangent of the cured product may increase.

Further, when the epoxy equivalent is greater than 400 g/eq, a low polar group concentration will be observed such that while the dielectric tangent of the cured product at room temperature will be sufficiently small, it may increase at 150°C which is as high as or higher than a glass-transition temperature.

In addition, if using two or more kinds of epoxy resins in combination, it is preferred that the epoxy equivalent in the composition as a whole fall into the abovementioned numerical range(s).

In terms of a lower limit of the heat-curable resin content in the resin composition for encapsulation, it is preferred that the heat-curable resin content be in an amount of, for example, not smaller than 3% by mass, more preferably not smaller than 4% by mass, particularly preferably not smaller than 5% by mass, with respect to the whole resin composition for encapsulation. When the amount of the heat-curable resin(s) added or contained is not smaller than the above lower limit(s), a fluidity of the resin composition for encapsulation can be improved such that improvements in moldability can be brought about. Meanwhile, in terms of an upper limit of the heat-curable resin content, it is preferred that the heat-curable resin content be in an amount of, for example, not larger than 50% by mass, more preferably not larger than 40% by mass, even more preferably not larger than 30% by mass, with respect to the whole resin composition for encapsulation. When the amount of the heat-curable resin(s) contained is not larger than the above upper limit(s), a power semiconductor device having the cured product of the resin composition for encapsulation can have its moisture resistance reliability and reflow resistance improved.

Inorganic filler

The resin composition for encapsulation of the present embodiment may contain an inorganic filler.

Specific examples of such inorganic filler include silicas such as a molten silica and a crystalline silica, cristobalite, alumina, silicon nitride, aluminum nitride, boron nitride, titanium oxide, glass fibers, alumina fibers, zinc oxide, talc, and calcium carbide. Silicas are preferred as the inorganic filler. As silicas, there may be listed, for example, a crushed molten silica, a spherical molten silica, a crystalline silica and a secondarily aggregated silica. Among these silicas, a spherical molten silica is particularly preferred.

The inorganic filler is normally in the form of particles. It is preferred that the particles each have a substantially spherical shape.

Atop cut size of the inorganic filler in a wet sieve analysis is preferably 20 to 150 μm, more preferably 53 to 75 μm. While there are no particular restrictions on an average particle size of the inorganic filler, it is typically 1 to 100 μm, preferably 1 to 50 μm, more preferably 1 to 20 μm. By adjusting the average particle size, an appropriate level of fluidity at the time of curing can be secured, for example.

The average particle size of the inorganic filler is calculated in such a manner where particle size distribution data on volumetric basis are at first obtained via a laser diffraction/scattering particle size distribution measurement device (e.g. Mastersizer 3000, a laser diffraction-type particle size distribution measurement device by Malvern Panalytical Ltd.), and a particle size corresponding to a cumulative percentage of 50% in the particle size distribution on volumetric basis (i.e. median size) is then regarded as the average particle size.

The inorganic filler such as silica may be previously (before preparing the resin composition for encapsulation by mixing all the components) surface-modified by a coupling agent such as a silane coupling agent.

In this way, aggregation of the inorganic filler can be inhibited such that a favorable fluidity can be achieved. Further, an affinity between the inorganic filler and other components will improve such that a dispersibility of the inorganic filler will improve. This shall contribute to, for example, improvements in mechanical strength of the cured product, and inhibition of microcrack occurrence.

As a coupling agent used to surface treat the inorganic filler, for example, when the heat-curable resin is an epoxy resin, there may be preferably used a primary amino silane such as γ-aminopropyltriethoxysilane and γ-aminopropyltrimethoxysilane, a (meth)acrylate resin, and a terminal (meth)acrylic group-modified polyphenylene ether resin; when the heat-curable resin is an unsaturated polyester resin, γ-methacryloxypropyltrimethoxysilane may be preferably used.

By modifying the surface of the inorganic filler with a group (e.g. amino group) capable of reacting with the heat-curable resin, the dispersibility of the inorganic filler in the resin composition for encapsulation can be improved.

Further, the fluidity of the resin composition for encapsulation and the strength thereof after curing, for example, can be controlled by appropriately selecting the kind of the coupling agent used to surface treat the inorganic filler, or by appropriately adjusting the amount of the coupling agent added.

The resin composition for encapsulation may contain only one kind of inorganic filler, or two or more kinds of inorganic fillers. If the resin composition for encapsulation contains an inorganic filler(s), in terms of a lower limit of the amount of the inorganic filler contained, it is preferred that the inorganic filler be in an amount of not smaller than 50% by mass, more preferably not smaller than 60% by mass, even more preferably not smaller than 70% by mass, with respect to the whole resin composition for encapsulation.

In terms of an upper limit of the amount of the inorganic filler contained, it is preferred that the inorganic filler be in an amount of, for example, not larger than 95% by mass, more preferably not larger than 93% by mass, even more preferably not larger than 90% by mass.

By appropriately adjusting the amount of the inorganic filler, curing and a flow characteristic of the composition, for example, can be appropriately adjusted while achieving a satisfactory HTRB test reliability.

Other additives

The resin composition for encapsulation of the present embodiment may further contain, if necessary, a curing agent, a curing accelerator, a mold release agent, a flame retardant, an ion trapping agent, a flexibility imparting agent, a colorant, an adhesiveness imparting agent, an antioxidant or other additives.

•Curing agent

There are no particular restrictions on a curing agent as long as it is capable of reacting with the heat-curable resin. For example, as a curing agent capable of reacting with an epoxy resin, there may be listed a phenol-based curing agent, an amine-based curing agent, an acid anhydride-based curing agent, an active ester-based curing agent and the like. Among these examples, a phenol-based curing agent is preferable in terms of a balance between, for example,

heat resistance, moisture resistance, electric properties, curability and preservation stability.

There are no particular restrictions on a phenol-based curing agent as long as the phenol-based curing agent employed is that generally used in a resin composition for encapsulation. For example, there may be listed a novolac resin such as a phenol novolac resin and a cresol novolac resin, which is obtained by condensing or co-condensing phenols and formaldehyde or ketones under the presence of an acidic catalyst; a phenol aralkyl resin such as a biphenylene skeleton-containing phenol aralkyl resin and a phenylene skeleton-containing phenol aralkyl resin, which is synthesized from phenols and dimethoxyparaxylene or bis(methoxymethyl)biphenyl; and a trisphenylmethane skeleton-containing phenolic resin.

Examples of the abovementioned phenols may include phenol, cresol, resorcinol, catechol, bisphenol A, bisphenol F, phenylphenol, aminophenol, $\alpha$-naphthol, $\beta$-naphthol and dihydroxynaphthalene.

Any one kind of them may be used alone, or two or more kinds of them may be used in combination.

Examples of an amine-based curing agent may include polyamine compounds such as aliphatic polyamines including diethylenetriamine (DETA), triethylenetetramine (TETA), methaxylylenediamine (MXDA) and the like; aromatic polyamines including diaminodiphenylmethane (DDM), m-phenylenediamine (MPDA), diaminodiphenylsulfone (DDS) and the like; dicyandiamide (DICY); and organic acid dihydrazide. Any one kind of them may be used alone, or two or more kinds of them may be used in combination.

Examples of an acid anhydride-based curing agent may include an alicyclic acid anhydride such as hexahydrophthalic anhydride (HHPA), methyltetrahydrophthalic anhydride (MTHPA) and maleic anhydride; and an aromatic acid anhydride such as trimellitic anhydride (TMA), pyromellitic anhydride (PMDA), benzophenone tetracarboxylic acid (BTDA) and phthalic anhydride. Any one kind of them may be used alone, or two or more kinds of them may be used in combination.

As an active ester-based curing agent, there may be used, for example, a curing agent having at least one active ester group per each molecule. As an active ester-based curing agent, preferred is a compound having per each molecule at least two ester groups possessing a high reaction activity, such as phenol esters, thiophenol esters, N-hydroxyamine esters, and esters of heterocyclic hydroxy compounds. It is preferred that such active ester-based curing agent be that obtained by a condensation reaction between a carboxylic acid compound and/or a thiocarboxylic acid compound; and a hydroxy compound and/or a thiol compound. Particularly, as a preferable specific example(s) of the active ester-based curing agent, there may be listed an active ester compound having a dicyclopentadiene-type diphenol structure, an active ester compound having a naphthalene structure, an active ester compound having an acetylated product of phenol novolac, and an active ester compound having a benzoylated product of phenol novolac. Among these examples, more preferred are an active ester compound having a naphthalene structure, and an active ester compound having a dicyclopentadiene-type diphenol structure. Here, a "dicyclopentadiene-type diphenol structure" refers to a divalent structure composed of phenylene-dicyclopentylene-phenylene.

The resin composition for encapsulation may contain only one kind of curing agent, or two or more kinds of curing agents.

It is preferred that the curing agent(s) be in an amount of not smaller than 0.5% by mass, more preferably not smaller than 1% by mass, particularly preferably not smaller than 1.5% by mass, with respect to the whole resin composition for encapsulation.

Meanwhile, it is preferred that the curing agent(s) be contained in an amount of not larger than 20% by mass, more preferably not larger than 15% by mass, particularly preferably not larger than 10% by mass, with respect to the whole resin composition for encapsulation.

By appropriately adjusting the amount of the curing agent, curing and a flow characteristic of the composition, for example, can be appropriately adjusted while achieving a satisfactory HTRB test reliability.

As another perspective, it is preferred that the amount of the curing agent be appropriately adjusted in relation to the amount of the heat-curable resin. Specifically, it is preferred that a so-called "molar equivalent" (molar ratio of reactive groups) be appropriately adjusted.

For example, when the heat-curable resin is an epoxy resin, and the curing agent is a phenol-based curing agent, the amount of the epoxy resin with respect to the phenol-based curing agent is preferably 0.6 to 1.3, more preferably 0.7 to 1.2, even more preferably 0.8 to 1.1, in terms of molar equivalent of functional groups (epoxy groups/hydroxy groups). •Curing accelerator

A curing accelerator may simply be a one capable of promoting a reaction of the heat-curable resin, or a reaction between the heat-curable resin and the curing agent.

For example, as a curing accelerator for use in an epoxy resin and a curing agent, there may be listed imidazoles such as 2-methylimidazole, 2-ethyl-4-methylimidazole, 2-methyl-4-ethylimidazole, 2-phenylimidazole and 2-methyl-4-methylimidazole; 1,8-diazabicyclo[5.4.0]undecene-7 and its salt, tertiary amines such as triethylenediamine and benzyldimethylamine; organic phosphines or the like such as triphenylphosphine, tributylphosphine and tetraphenylphosphonium-tetraphenylborate, and those prepared by microencapsulating these organic phosphines; and urea structure-containing compounds such as N,N,N',N'-tetramethylurea, N'-phenyl-N, N-dimethylurea, N,N-diethylurea,

N'-[3-[[[(dimethylamino)carbonyl]amino]methyl]-3,5,5-trimethylcyclohexyl]-N,N-dimethylurea, and N,N''-(4-methyl-1,3-phenylene)bis(N',N'-dimethylurea). Any one kind of them may be used alone, or two or more kinds of them may be used in combination.

Among these examples, in terms of improving the HTRB test reliability, preferred are 1,8-diazabicyclo[5.4.0]undecene-7 and its salt; tertiary amines such as triethylenediamine and benzyldimethylamine; and urea structure-containing compounds such as N,N,N',N'-tetramethylurea, N'-phenyl-N, N-dimethylurea, N,N-diethylurea, N'-[3-[[[(dimethylamino)carbonyl]amino]methyl]-3,5,5-trimethylcyclohexyl]-N,N-dimethylurea, and N,N''-(4-methyl-1,3-phenylene)bis(N',N'-dimethylurea).

Particularly, in terms of having a potentiality for causing curing reaction not until a given temperature has been reached, preferred are N,N-diethylurea and N'-[3-[[[(dimethylamino)carbonyl]amino]methyl]-3,5,5-trimethylcyclohexyl]-N,N-dimethylurea.

It is preferred that the curing accelerator be added in an amount of 0.5 to 10.0 parts by mass, more preferably 1.5 to 6.0 parts by mass, per a total of 100 parts by mass of the epoxy resin and the curing agent component. When the amount of the curing accelerator added is within these ranges, the epoxy groups and the functional groups in the curing agent are able to rapidly react with each other such that the cured product can be easily obtained.

•Mold release agent

As a mold release agent, there may be listed, for example, waxes such as carnauba wax, rice wax, polyethylene, oxidized polyethylene, montanic acid, and ester compounds of montanic acid with, for example, a saturated alcohol, 2-(2-hydroxyethylamino)-ethanol, ethylene glycol or glycerin; and stearic acid, stearic acid ester, stearic acid amide, ethylenebisstearic acid amide, and a copolymer of ethylene and vinyl acetate. Any one kind of them may be used alone, or two or more kinds of them may be used in combination.

Among these examples, in terms of improving the HTRB test reliability, preferred are, for example, polyethylene, oxidized polyethylene, ethylenebisstearic acid amide, and a copolymer of ethylene and vinyl acetate, which have low acid values.

•Flame retardant

As a flame retardant, there may be listed, for example, a halogenated epoxy resin, a phosphazene compound, a silicone compound, zinc molybdate-supported talc, zinc molybdate-supported zinc oxide, aluminum hydroxide, magnesium hydroxide, molybdenum oxide and antimony trioxide. Any one kind of these flame retardants may be used alone, or two or more kinds of them may be used in combination; aluminum hydroxide is preferably used in terms of improvement in HTRB test reliability and environmental load.

It is preferred that aluminum hydroxide contain few impurity ions. As a standard for aluminum hydroxide to contain few impurity ions therein, specifically, it is preferred that sodium ions be in an amount of not larger than 20 ppm, and chloride ions be in an amount of not larger than 5 ppm, when extracted at 125°C for 20 hours.

Ion trapping agent

As an ion trapping agent, there may be listed, for example, a hydrotalcite compound, a bismuth compound and a zirconium compound; any one kind of them may be used alone, or two or more kinds of them may be used in combination.

•Flexibility imparting agent

As a flexibility imparting agent, there may be listed, for example, a silicone compound such as a silicone oil, a silicone resin, a silicone-modified epoxy resin and a silicone-modified phenolic resin; and a thermoplastic elastomer such as a styrene resin and an acrylic resin. Any one kind of them may be used alone, or two or more kinds of them may be used in combination.

As a flexibility imparting agent, a silicone-modified epoxy resin is preferred; particularly preferred is a copolymer compound obtained by a hydrosilylation reaction between an alkenyl group-containing epoxy compound and a hydrogen organopolysiloxane represented by the following average formula (1):

$$H_aR_bSiO_{\frac{4-(a+b)}{2}} \qquad (1)$$

wherein R represents a substituted or unsubstituted monovalent hydrocarbon group having 1 to 10, preferably 1 to 6 carbon atoms; a and b satisfy $0.01 \leq a \leq 1$, $1 \leq b \leq 3$, and $1.01 \leq a+b<4$.

The alkenyl group-containing epoxy compound can be obtained by, for example, epoxidizing an alkenyl group-containing phenolic resin with epichlorohydrin, or partially reacting 2-allylphenol with a known epoxy compound. This epoxy compound is a compound having at least one alkenyl group per each molecule, and may for example be expressed by the following average formula (2):

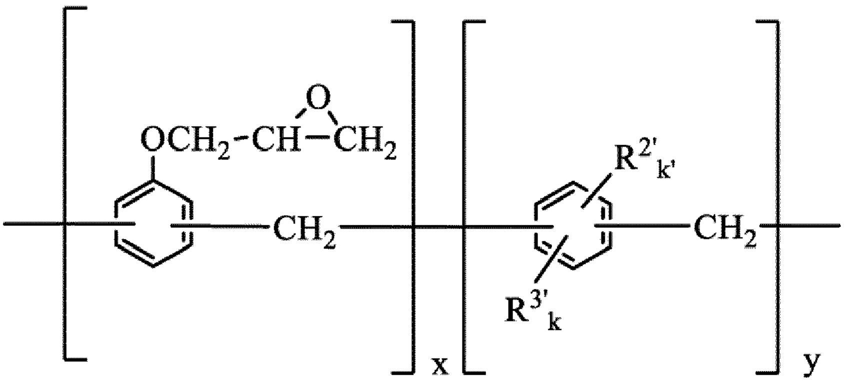

(2)

wherein $R^{2'}$ represents an alkenyl group-containing aliphatic monovalent hydrocarbon group having 3 to 15, preferably 3 to 5 carbon atoms; $R^{3'}$ represents a glycidyl group or a group expressed by $-OCH_2CH(OH)CH_2OR'$ in which R' represents an alkenyl group-containing monovalent hydrocarbon group having 3 to 10, preferably 3 to 5 carbon atoms; k is 1, k' is 0 or 1, x is a number of 1 to 30, y is a number of 1 to 3.

As the epoxy compound represented by the average formula (2), there may be employed, for example, the following compound:

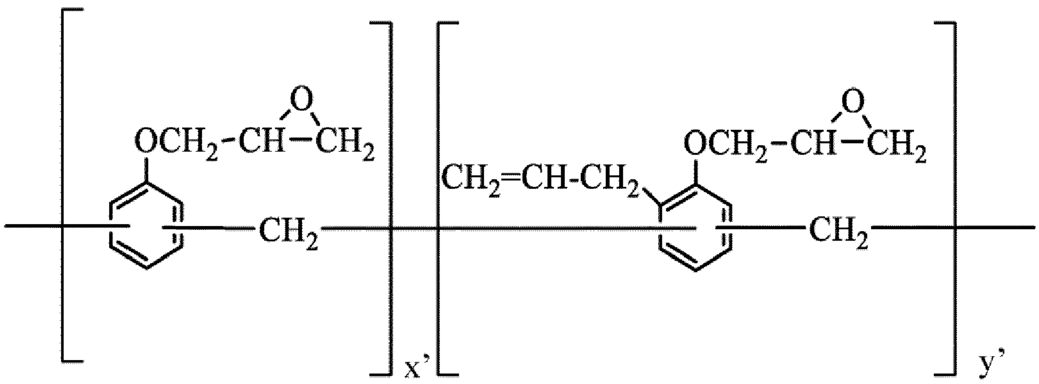

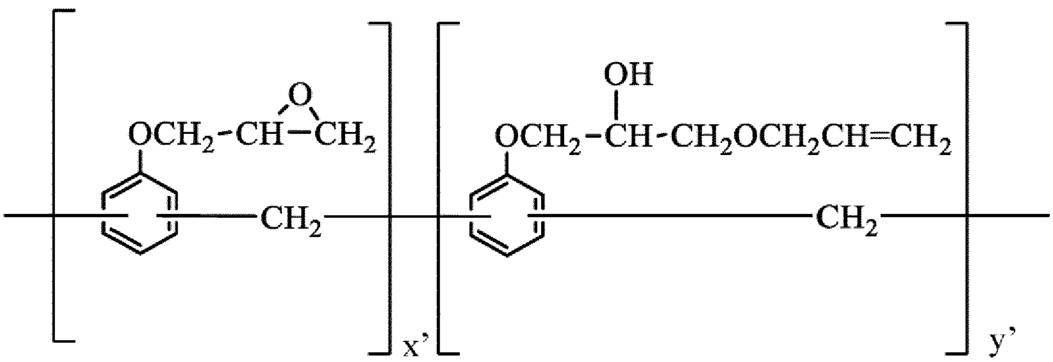

wherein x' and y' are numbers satisfying $1<x'<10$ and $1<y'<3$.

The hydrogen organopolysiloxane represented by the average formula (1) has at least one SiH group per each molecule. In the formula (1), R may represent, for example, an alkyl group such as a methyl group, an ethyl group, a

propyl group, an isopropyl group, a butyl group, an isobutyl group, a tert-butyl group, a pentyl group, a neopentyl group, a hexyl group, an octyl group, a nonyl group and a decyl group; an alkenyl group such as a vinyl group, an allyl group, a propenyl group, an isopropenyl group, a butenyl group, a hexenyl group, a cyclohexenyl group and an octenyl group; an aryl group such as a phenyl group, a tolyl group, a xylyl group and a naphthyl group; an aralkyl group such as a benzyl group, a phenylethyl group and a phenylpropyl group; or a group obtained by substituting part of or all the hydrogen atoms in any of these groups with, for example, halogen atoms such as fluorine, bromine and chlorine atoms and/or cyano groups, examples of such substituted group including a halogen-substituted alkyl group such as a chloromethyl group, a chloropropyl group, a bromoethyl group and a trifluoropropyl group, as well as a cyanoethyl group. Preferred are a methyl group, an ethyl group and a phenyl group.

The hydrogen organopolysiloxane represented by the average formula (1) may be either linear, cyclic or branched. More specifically, the hydrogen organopolysiloxane represented by the average formula (1) may for example be expressed by the following formulae (a) to (c).

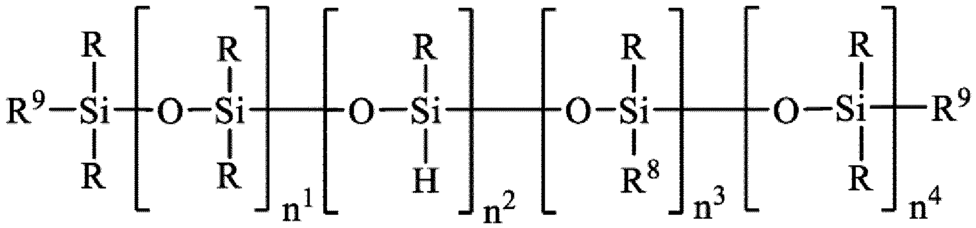

(a)

In the above formula (a), each R independently represents a substituted or unsubstituted monovalent hydrocarbon group having 1 to 10, preferably 1 to 6 carbon atoms; each $R^9$ independently represents a hydrogen atom or a group selected from the options of R; $R^8$ represents a group expressed by the following formula (3). $n^1$ is an integer of 5 to 200; $n^2$ is an integer of 0 to 2; $n^3$ is an integer of 0 to 10; $n^4$ is 1 or 0.

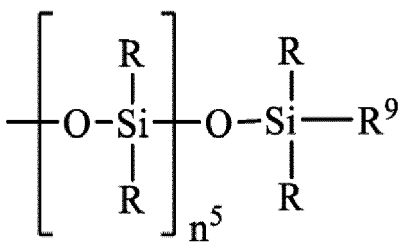

(3)

In the formula (3), R and $R^9$ are defined as above in the formula (a), and $n^5$ is an integer of 1 to 10. However, the compound of the formula (a) has at least one silicon atom-bonded hydrogen atom per each molecule.

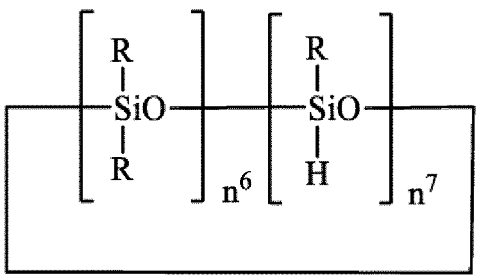

(b)

In the formula (b), R is defined as above in the formula (a), $n^6$ is an integer of 1 to 10, and $n^7$ is 1 or 2.

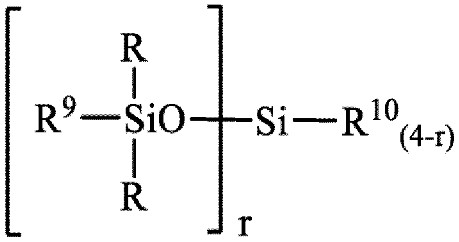

( c )

In the formula (c), R and $R^9$ are defined as above in the formula (a); r is an integer of 0 to 3; $R^{10}$ represents a hydrogen atom or a monovalent hydrocarbon group that has 1 to 10 carbon atoms and may have an oxygen atom(s). The compound of the formula (c) has at least one silicon atom-bonded hydrogen atom per each molecule.

As the above hydrogen organopolysiloxane, preferred are, for example, a dual-end hydrogen methylpolysiloxane and a dual-end hydrogen methylphenylpolysiloxane. For example, the following compounds are preferred.

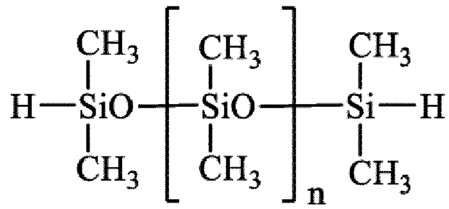

In this formula, n is an integer of 20 to 100.

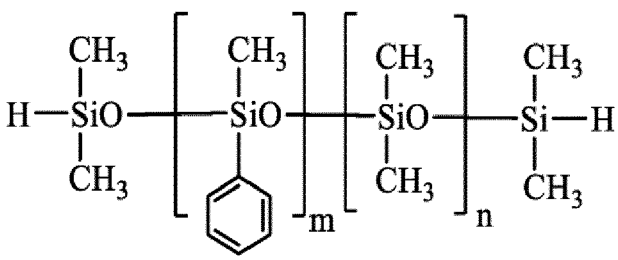

In this formula, m is an integer of 1 to 10, n is an integer of 10 to 100.

•Colorant

As a colorant, there may be listed, for example, carbon black, titanium black and titanium oxide; any one kind of them may be used alone, or two or more kinds of them may be used in combination.

•Adhesiveness imparting agent

There are no particular restrictions on an adhesiveness imparting agent; a known adhesiveness imparting agent may be used. For example, there may be listed silane coupling agents including epoxysilanes such as γ-glycidoxypropyltrimethoxysilane, γ-glycidoxypropylmethyldiethoxysilane and β-(3,4-epoxycyclohexyl)ethyltrimethoxysilane; aminosilanes such as N-β(aminoethyl)-γ-aminopropyltrimethoxysilane, γ-aminopropyltriethoxysilane and N-phenyl-γ-aminopropyltrimethoxysilane; and mercaptosilanes such as γ-mercaptopropyltrimethoxysilane and γ-mercaptopropylmethyldimethoxysilane. Any one kind of them may be used alone, or two or more kinds of them may be used in combination.

•Antioxidant

As an antioxidant, there may be listed, for example, a phenol-based antioxidant (e.g. dibutylhydroxytoluene), a sulfur-based antioxidant (e.g. mercaptopropionic acid derivative) and a phosphorus-based antioxidant (e.g. 9,10-dihydro-9-oxa-10-phosphaphenanthrene-10-oxide). If using an antioxidant, there may be used only one kind thereof, or two or more kinds thereof in combination.

The amount of these other additives contained in the resin composition for encapsulation may be appropriately determined within the ranges by which the function of each additive can be favorably exhibited; for example, the amount thereof may be in a range of 0.1 to 30 parts by mass per 100 parts by mass of the heat-curable resin components (which also include the curing agent if the curing agent is used).

Method for producing resin composition for encapsulation

The resin composition for encapsulation of the present invention may for example be produced as follows. That is, given amounts of the heat-curable resin, inorganic filler and other additives are to be combined and then sufficiently uniformly mixed by a mixer or the like, followed by performing a melt mixing treatment with a heated roller, a kneader, an extruder or the like, cooling the mixture so as to solidify the same, and then crushing the solidified product into an appropriate size(s); the composition thus obtained can be used as a molding material. Further, the composition may also be tableted so as to be used in the form of a tablet(s).

Use of resin composition for encapsulation

The resin composition for encapsulation of the present invention is useful as an encapsulation resin for a power semiconductor device of, for example, a transistor type, a module type, a DIP type, a SO type, a flatpack type, a wafer level package type or a fan out package type, that is equipped with a power semiconductor element(s) made of Si, SiC, GaN, $Ga_2O_3$ or diamond. There are no particular restrictions on a method for encapsulating a semiconductor device with the resin composition for encapsulation of the present invention; there may be employed a conventional molding method such as transfer molding, injection molding, compression molding or cast molding.

Cured product of resin composition for encapsulation

Although there are no particular restrictions on a molding (curing) condition(s) of the resin composition for encapsulation of the present invention, it is preferred that the composition be treated at 120 to 190°C for 60 to 300 sec. Further, it is preferred that post curing be performed at 150 to 250°C for 0.5 to 8 hours.

Semiconductor device

The semiconductor device of the present invention is such that a power semiconductor element(s) made of Si, SiC, GaN, $Ga_2O_3$ or diamond are encapsulated by the cured product of the resin composition for encapsulation. Using the resin composition for encapsulation, this semiconductor device may be produced by, for example, the encapsulation method(s) described in the use of the resin composition for encapsulation.

Further, the following methods are provided.

There is provided a method for improving the HTRB test reliability of the semiconductor device, the method comprising steps of:

encapsulating a power semiconductor element(s) made of Si, SiC, GaN, $Ga_2O_3$ or diamond with the cured product of the resin composition for encapsulation to produce a semiconductor device; and
carrying out a high-temperature reverse bias test (HTRB test) using the semiconductor device and suppressing an increase of a leakage current.

There is also provided a method for producing or evaluating a semiconductor device, the method comprising steps of:

encapsulating a power semiconductor element(s) made of Si, SiC, GaN, $Ga_2O_3$ or diamond with the cured product of the resin composition for encapsulation to produce a semiconductor device; and
carrying out a high-temperature reverse bias test (HTRB test) using the semiconductor device, or further evaluating the reliability thereof via the test.

The embodiment(s) of the present invention have been described heretofore; these embodiments merely serve as examples of the present invention, and various constitutions other than those introduced above may be employed. Further, the present invention is not limited to the above embodiments; any modifications, improvements or the like shall be encompassed by the present invention so long as they are made within the scope by which the purposes of the present invention can be achieved.

WORKING EXAMPLES

The present invention is described in greater detail hereunder with reference to working and comparative examples. However, the present invention shall not be limited to the following working examples.

Heat-curable resin

Epoxy resin 1: NC-3000H (by Nippon Kayaku Co.,Ltd., biphenyl aralkyl type, epoxy equivalent 272 g/eq)
Epoxy resin 2: EPICLON HP-7200 (by DIC CORPORATION, dicyclopentadiene type, epoxy equivalent 258 g/eq)
Epoxy resin 3: FAE-2500 (by Nippon Kayaku Co.,Ltd., alkyl-modified trisphenolmethane novolac type, epoxy equivalent 220 g/eq)
Epoxy resin 4: EPPN-502H (by Nippon Kayaku Co.,Ltd., trisphenolmethane novolac type, epoxy equivalent 168 g/eq)
Epoxy resin 5: EPICLON HP-7400 (by DIC CORPORATION, trisphenolmethane novolac type, epoxy equivalent 169 g/eq)
Epoxy resin 6: NC-3500 (by Nippon Kayaku Co.,Ltd., biphenyl aralkyl type, epoxy equivalent 210 g/eq)

Inorganic filler

Spherical molten silica: by TATSUMORI LTD., average particle size=12 μm
Crushed molten silica: by Fumitec Co., Ltd., average particle size=15 μm
Spherical alumina: by Denka Company Limited., average particle size=15 μm

Other additives

Flexibility imparting agent: copolymer of alkenyl group-containing epoxy resin and polyorganosiloxane (by Shin-Etsu Chemical Co., Ltd., epoxy equivalent 402 g/eq)
Curing agent: phenolic resin TD-2093Y (by MEIWA PLASTIC INDUSTRIES,LTD., OH group equivalent 110 g/eq)
Mold release agent 1: synthetic wax RIKEMAL SL-962 (by RIKEN VITAMIN CO., LTD.)
Mold release agent 2: carnauba wax TOWAX-131 (by TOA KASEI CO., LTD.)
Colorant: carbon black DENKA BLACK (by Denka Company Limited.)
Curing accelerator 1: N'-[3-[[[(dimethylamino)carbonyl]amino]methyl]-3,5,5-trimethylcyclohexyl]-N,N-dimethylurea U-cat 3513N (by San-Apro Ltd.)
Curing accelerator 2: mixture of 1,8-diazabicyclo[5.4.0]undecene-7 and phenol novolac resin U-cat SA851 (by San-Apro Ltd.)
Curing accelerator 3: adduct of triphenylphosphine and 1,4-benzoquinone
Flame retardant 1: phosphazene Rabitle FP-100 (by FUSHIMI Pharmaceutical Co.,Ltd.)
Flame retardant 2: zinc molybdate-supported talc KEMGARD-911C (by Huber Engineered Materials)
Flame retardant 3: aluminum hydroxide BF083 (by Nippon Light Metal Company, Ltd.)
Ion trapping agent: hydrotalcite compound DHT-4A-2 (by Kyowa Chemical Industry Co.,Ltd.)
Adhesiveness imparting agent 1: γ-mercaptopropyltrimethoxysilane KBM-803 (by Shin-Etsu Chemical Co., Ltd.)
Adhesiveness imparting agent 2: γ-glycidoxypropyltrimethoxysilane KBM-403 (by Shin-Etsu Chemical Co., Ltd.)
Working examples 1 to 6; comparative examples 1 to 6

The above components were combined in accordance with the compositions (parts by mass) shown in Tables 1 and 2; in each of working examples 1 to 6 and comparative examples 1 to 6, the components were subjected to melt mixing, cooling and then crushing to obtain a resin composition for encapsulation. Each composition was evaluated by the following methods, and the results thereof are shown in Tables 3 and 4.

Preparation of test piece for dielectric property evaluation

Using a transfer molding machine, the resin composition for encapsulation obtained in each of the working and comparative examples was subjected to injection molding with the aid of a mold under a condition(s) of: mold temperature 175°C; injection pressure 6.9 MPa; curing time 2 min. The composition was thereby molded into a circular shape having a diameter of 50 mm and a thickness of 3 mm. After molding, an oven was used to perform post curing at 180°C for four hours. Next, the post-cured product was cooled to room temperature to obtain a test piece for dielectric property evaluation. Au was then evaporated onto an electrode contacting portion on the surface of the test piece via ion sputtering. Before

measurement, the test piece was stored in a desiccator controlled to a temperature of 20±5°C, and a humidity of 15±5% RH Dielectric tangent, permittivity, dielectric loss

With regard to the obtained test piece for evaluation (cured product of resin composition for encapsulation), E2912A manufactured by Keysight Technologies was used to measure the following properties in a high-temperature thermostatic device (PHH102 by ESPEC CORP.). The results thereof are shown in Tables 3 and 4.

- Dielectric tangent at 150°C, 0.1 Hz
- Permittivity at 150°C, 0.1 Hz
- Dielectric loss at 150°C, 0.1 Hz
- Dielectric tangent at 150°C, 1 Hz
- Permittivity at 150°C, 1 Hz
- Dielectric loss at 150°C, 1 Hz
- Dielectric tangent at 25°C, 0.1 Hz
- Permittivity at 25°C, 0.1 Hz
- Dielectric loss at 25°C, 0.1 Hz
- Dielectric tangent at 25°C, 1 Hz
- Permittivity at 25°C, 1 Hz
- Dielectric loss at 25°C, 1 Hz

HTRB test: evaluation of HTRB reliability

At first, an IGBT (insulated gate bipolar transistor) element with a rated withstand voltage $V_{CE}$ of 1,200 V was bonded to a frame for package specification: TO-247 with an Au80Sn20 brazing material via die bonding, followed by performing wire bonding thereon using an Al wire. The wire-bonded product was then encapsulated by the resin composition for encapsulation prepared in each of the working and comparative examples, thereby obtaining a package for HTRB evaluation. Here, a molding condition of the resin composition for encapsulation was 175°C for 2 min; and a post curing condition was 180°C for four hours.

The withstand voltage $V_{CE}$ of the package for HTRB evaluation was measured by a semiconductor curve tracer (model CS-3100) manufactured by IWATSU ELECTRIC CO.,LTD. The voltage applied between the collector and emitter was raised at a constant rate, where a voltage at which a leakage of 10 nA was observed was recorded as the withstand voltage.

A high-temperature thermostatic bath (model: STH-120) manufactured by ESPEC CORP. was set to 150°C, and the package for HTRB evaluation was then placed into the thermostatic bath. Next, a high-voltage power source (model: HV$\alpha$-2K 125P1) was used to keep applying a DC voltage of 960 V to the package for HTRB evaluation for 24 hours.

Next, the thermostatic bath was returned to normal temperature, the voltage applied was turned off, and the package for HTRB evaluation was then removed from the thermostatic bath. The withstand voltage $V_{CE}$ of the package taken out was measured by the curve tracer. The voltage applied between the collector and emitter was raised at a constant rate, where a voltage at which a leakage of 10 nA was observed was recorded as the withstand voltage. A decrease in the withstand voltage before and after the HTRB test was obtained. HTRB test was performed on the package for HTRB evaluation under each condition with a sample size being N=5, the decrease in the withstand voltage was then calculated as an average value; the results thereof are shown in Tables 3 and 4.

Table 1

| Composition table (part by mass) | | Working example | | | | | |
|---|---|---|---|---|---|---|---|
| | | 1 | 2 | 3 | 4 | 5 | 6 |
| Inorganic filler | Spherical molten silica | 400 | 400 | 400 | 400 | 500 | 800 |
| | Crushed molten silica | | | | | | |
| | Alumina | | | | | 350 | |

(continued)

| Composition table (part by mass) | | Working example | | | | | |
|---|---|---|---|---|---|---|---|
| | | 1 | 2 | 3 | 4 | 5 | 6 |
| Heat-curable resin | Epoxy resin 1 | | 71.20 | | 69.19 | | |
| | Epoxy resin 2 | | | | | 35.00 | 35.00 |
| | Epoxy resin 3 | 66.05 | | 66.05 | | | |
| | Epoxy resin 4 | | | | | 16.85 | 16.85 |
| | Epoxy resin 5 | | | | | | |
| | Epoxy resin 6 | | | | | | |
| Other additives | Flexibility imparting agent | | | | | 16.71 | 16.71 |
| | Curing agent | 33.95 | 28.80 | 33.95 | 30.81 | 30.84 | 30.84 |
| | Mold release agent 1 | 1 | 1 | 1 | 1 | | |
| | Mold release agent 2 | | | | | 1.5 | 1.5 |
| | Colorant | 1 | 1 | 1 | 1 | 1.5 | 1.5 |
| | Curing accelerator 1 | 1.8 | 1.8 | 1.8 | 1.8 | | 1.8 |
| | Curing accelerator 2 | | | | | 1.0 | |
| | Curing accelerator 3 | | | | | 0.7 | |
| | Flame retardant 1 | | | | | 2.0 | 5.0 |
| | Flame retardant 2 | | | | | 1.5 | |
| | Flame retardant 3 | | | | | | 10 |
| | Ion trapping agent | | | | | 1.5 | 1.5 |
| | Adhesiveness imparting agent1 | | 1.5 | 1.5 | 1.5 | 0.4 | 0.4 |
| | Adhesiveness imparting agent2 | | | | | 1.5 | 1.5 |

Table 2

| Composition table (part by mass) | | Comparative example | | | | | |
|---|---|---|---|---|---|---|---|
| | | 1 | 2 | 3 | 4 | 5 | 6 |
| Inorganic filler | Spherical molten silica | 400 | 400 | 400 | 400 | 400 | 280 |
| | Crushed molten silica | | | | | | 120 |
| | Alumina | | | | | | |
| Heat-curable resin | Epoxy resin 1 | | | | | | |
| | Epoxy resin 2 | | | | | | |
| | Epoxy resin 3 | | | | | | |
| | Epoxy resin 4 | | 60.43 | 33.37 | 60.43 | | 36.24 |
| | Epoxy resin 5 | | | | | 60.43 | |
| | Epoxy resin 6 | 65.62 | | | | | |

(continued)

| Composition table (part by mass) | | Comparative example | | | | | |
|---|---|---|---|---|---|---|---|
| | | 1 | 2 | 3 | 4 | 5 | 6 |
| Other additives | Flexibility imparting agent | | | 33.20 | | | 24.9 |
| | Curing agent | 34.38 | 39.57 | 33.33 | 39.57 | 39.57 | 30.26 |
| | Mold release agent 1 | 1 | 1 | 1 | 1 | 1 | |
| | Mold release agent 2 | | | | | | 1.5 |
| | Colorant | 1 | 1 | 1 | 1 | 1 | 1.5 |
| | Curing accelerator 1 | 1.8 | 1.8 | 1.8 | 1.8 | 1.8 | |
| | Curing accelerator 2 | | | | | | 1.0 |
| | Curing accelerator 3 | | | | | | 1.0 |
| | Flame retardant 1 | | | | | | 5.0 |
| | Flame retardant 2 | | | | | | 5.0 |
| | Flame retardant 3 | | | | | | |
| | Ion trapping agent | | | | | | 1.5 |
| | Adhesiveness imparting agent1 | 1.5 | 1.5 | 1.5 | | | |
| | Adhesiveness imparting agent2 | | | | 1.5 | | 1.5 |

Table 3

| | | | Working example | | | | | |
|---|---|---|---|---|---|---|---|---|
| | | | 1 | 2 | 3 | 4 | 5 | 6 |
| Decrease in withstand voltage before and after HTRB test (V) | | | 0 | 0 | 0 | 0 | 0 | 0 |
| 150°C | 0.1Hz | Dielectric tangent | 0.03 | 0.30 | 0.27 | 0.37 | 0.05 | 0.08 |
| 150°C | 0.1Hz | Permittivity | 3.64 | 4.6 | 4.27 | 7.37 | 5.06 | 4.46 |
| 150°C | 0.1Hz | Dielectric loss | 0.12 | 1.38 | 1.14 | 2.70 | 0.23 | 0.34 |
| 150°C | 1Hz | Dielectric tangent | 0.012 | 0.06 | 0.04 | 0.15 | 0.02 | 0.02 |
| 150°C | 1Hz | Permittivity | 3.61 | 4.26 | 3.89 | 5.35 | 4.94 | 4.28 |
| 150°C | 1Hz | Dielectric loss | 0.04 | 0.24 | 0.17 | 0.84 | 0.09 | 0.09 |
| 25°C | 0.1Hz | Dielectric tangent | 0.007 | 0.016 | 0.002 | 0.014 | 0.006 | 0.014 |
| 25°C | 0.1Hz | Permittivity | 3.68 | 4.25 | 4.02 | 4.40 | 4.98 | 4.19 |
| 25°C | 0.1Hz | Dielectric loss | 0.025 | 0.068 | 0.008 | 0.063 | 0.027 | 0.058 |
| 25°C | 1Hz | Dielectric tangent | 0.001 | 0.007 | 0.002 | 0.007 | 0.003 | 0.005 |
| 25°C | 1Hz | Permittivity | 3.67 | 4.21 | 4.01 | 4.34 | 4.97 | 4.17 |
| 25°C | 1Hz | Dielectric loss | 0.005 | 0.028 | 0.007 | 0.031 | 0.014 | 0.018 |

Table 4

| | | | Comparative example | | | | | |
|---|---|---|---|---|---|---|---|---|
| | | | 1 | 2 | 3 | 4 | 5 | 6 |
| Decrease in withstand voltage before and after HTRB test (V) | | | 9 | 26 | 16 | 12 | 18 | 28 |
| 150°C | 0.1Hz | Dielectric tangent | 0.55 | 0.80 | 0.79 | 0.58 | 0.67 | 0.83 |
| 150°C | 0.1Hz | Permittivity | 5.10 | 6.10 | 6.93 | 5.34 | 5.39 | 7.95 |
| 150°C | 0.1Hz | Dielectric loss | 2.80 | 4.93 | 5.44 | 3.08 | 3.67 | 0.59 |
| 150°C | 1Hz | Dielectric tangent | 0.11 | 0.18 | 0.25 | 0.106 | 0.135 | 0.299 |
| 150°C | 1Hz | Permittivity | 4.00 | 4.70 | 4.2 | 4.41 | 4.31 | 4.34 |
| 150°C | 1Hz | Dielectric loss | 0.46 | 0.81 | 1.04 | 0.47 | 0.58 | 1.3 |
| 25°C | 0.1Hz | Dielectric tangent | 0.005 | 0.8 | 0.001 | 0.017 | 0.021 | 0.011 |
| 25°C | 0.1Hz | Permittivity | 4.06 | 6.13 | 3.99 | 4.4 | 4.26 | 3.97 |
| 25°C | 0.1Hz | Dielectric loss | 0.002 | 4.93 | 0.004 | 0.074 | 0.088 | 0.04 |
| 25°C | 1Hz | Dielectric tangent | 0.002 | 0.18 | 0.003 | 0.007 | 0.01 | 0.003 |
| 25°C | 1Hz | Permittivity | 4.05 | 4.57 | 3.97 | 4.36 | 4.19 | 3.96 |
| 25°C | 1Hz | Dielectric loss | 0.01 | 0.81 | 0.01 | 0.03 | 0.04 | 0.011 |

FIG.1 is a graph plotting the decreases in the withstand voltage (V) before and after the HTRB test with respect to the values of dielectric tangent measured at 150°C and 0.1 Hz, in the case of the cured product of the composition prepared in each of the working and comparative examples.

As shown in Tables 3 and 4 as well as FIG.1, the cured product of the resin composition for encapsulation of the present invention has a dielectric tangent of not larger than 0.5 when measured at 150°C and 0.1 Hz; provided is a cured product causing no decrease in withstand voltage when performing a HTRB test on a power semiconductor.

## Claims

1. A resin composition for encapsulation used to encapsulate a power semiconductor element made of Si, SiC, GaN, $Ga_2O_3$ or diamond, wherein a cured product of the resin composition for encapsulation has a dielectric tangent of not larger than 0.50 when measured at 150°C and 0.1 Hz.

2. The resin composition for encapsulation according to claim 1, comprising a heat-curable resin.

3. The resin composition for encapsulation according to claim 2, wherein the heat-curable resin is an epoxy resin.

4. The resin composition for encapsulation according to claim 3, wherein the epoxy resin contains at least one selected from the group consisting of a trisphenolmethane-type epoxy resin, an alkyl-modified trisphenolmethane-type epoxy resin, a phenol aralkyl-type epoxy resin having a biphenylene skeleton and a dicyclopentadiene-modified phenol-type epoxy resin.

5. The resin composition for encapsulation according to claim 3, wherein the epoxy resin has an epoxy equivalent of 220 to 300 g/eq.

6. The resin composition for encapsulation according to any one of claims 1 to 5, further comprising an inorganic filler.

7. The resin composition for encapsulation according to claim 6, wherein the inorganic filler contains silicas.

8. A semiconductor device wherein a power semiconductor element made of Si, SiC, GaN, $Ga_2O_3$ or diamond is encapsulated by a cured product of the resin composition for encapsulation according to any one of claims 1 to 7.

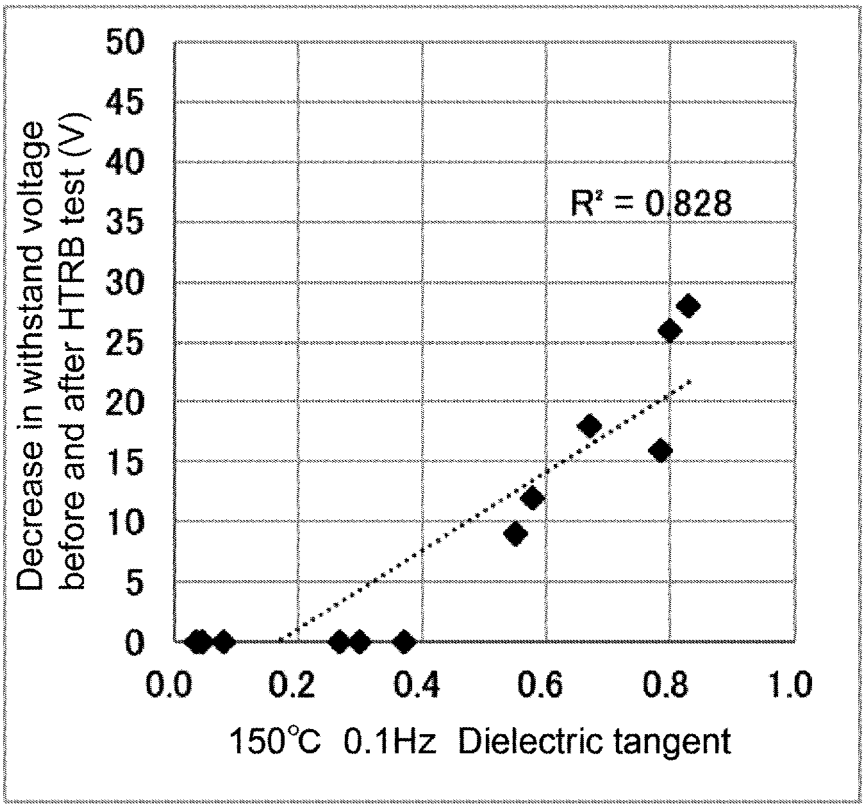

50
45
40
35
30
25
20
15
10
5
0
Decrease in withstand voltage before and after HTRB test (V)
$R^2 = 0.828$
0.0
0.2
0.4
0.6
0.8
1.0
150°C 0.1Hz Dielectric tangent

European Patent Office / Europäisches Patentamt / Office européen des brevets

# EUROPEAN SEARCH REPORT

Application Number
EP 22 16 9009

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/090491 A1 (SUMITOMO BAKELITE CO [JP]) 7 May 2020 (2020-05-07) * Comparative Example 5; paragraph [0125]; claims 1-7; table 1 * | 1-8 | INV. C08K3/36 C08L63/00 |
| X | EP 0 953 603 B1 (SHINETSU CHEMICAL CO [JP]) 3 March 2004 (2004-03-03) * claims 1-11; examples 5-7; table 1 * | 1-8 | |
| X | JP 2007 092002 A (HITACHI CHEMICAL CO LTD; YOSHIKAWA KOGYO KK) 12 April 2007 (2007-04-12) * Comparative Example 5; claims 1-4; table 2 * | 1-8 | |
| X<br>A | US 10 793 712 B2 (SHINETSU CHEMICAL CO [JP]) 6 October 2020 (2020-10-06) * column 20, line 16 - line 24; claims 1-6; examples 2, 4 * | 1-4,6-8<br>5 | |

TECHNICAL FIELDS SEARCHED (IPC)
C08K

The present search report has been drawn up for all claims

1

| Place of search | Date of completion of the search | Examiner |
|---|---|---|
| Munich | 6 October 2022 | Neumeier, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 22 16 9009

This annex lists the patent family members relating to the patent documents cited in the above-mentioned European search report. The members are as contained in the European Patent Office EDP file on
The European Patent Office is in no way liable for these particulars which are merely given for the purpose of information.

06-10-2022

| Patent document cited in search report | Publication date | Patent family member(s) | Publication date |
|---|---|---|---|
| WO 2020090491 A1 | 07-05-2020 | CN 112997299 A | 18-06-2021 |
| | | EP 3876273 A1 | 08-09-2021 |
| | | JP 6933300 B2 | 08-09-2021 |
| | | JP 2021119248 A | 12-08-2021 |
| | | JP WO2020090491 A1 | 15-02-2021 |
| | | KR 20210087477 A | 12-07-2021 |
| | | US 2021384573 A1 | 09-12-2021 |
| | | WO 2020090491 A1 | 07-05-2020 |
| EP 0953603 B1 | 03-03-2004 | DE 69915161 T2 | 17-03-2005 |
| | | EP 0953603 A2 | 03-11-1999 |
| | | JP 3479827 B2 | 15-12-2003 |
| | | JP H11310688 A | 09-11-1999 |
| | | KR 19990083454 A | 25-11-1999 |
| | | US 2002102429 A1 | 01-08-2002 |
| JP 2007092002 A | 12-04-2007 | NONE | |
| US 10793712 B2 | 06-10-2020 | CN 110819068 A | 21-02-2020 |
| | | JP 7087810 B2 | 21-06-2022 |
| | | JP 2020026450 A | 20-02-2020 |
| | | KR 20200018288 A | 19-02-2020 |
| | | TW 202009272 A | 01-03-2020 |
| | | US 2020048454 A1 | 13-02-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP SHO6181426 A
- JP 2020158684 A
- WO 2019035430 A